# EUROPÄISCHE PATENTSCHRIFT

(11) **EP 0 419 851 B1**
(45) Veröffentlichungstag und Bekanntmachung des Hinweises auf die Patenterteilung: **01.09.1993**
(21) Anmeldenummer: 90116137.2
(22) Anmeldetag: 23.08.1990
(51) Int. Cl.: C25D 17/06

(54) **Haltevorrichtung für zu galvanisierende Gegenstände**
Holder for articles to be electroplated
Support pour articles devant recevoir un dépôt électrolytique

(30) Priorität: 31.08.1989 DE 8910413 U
(43) Veröffentlichungstag der Anmeldung: 03.04.1991
(73) Patentinhaber: METZKA GmbH, D-90596 Schwanstetten (DE)
(72) Erfinder: Metzka, Hans Joachim, D-8500 Nürnberg (DE)
(74) Vertreter: LOUIS, PÖHLAU, LOHRENTZ & SEGETH

(56) Entgegenhaltungen:
- US-A- 2 831 808
- US-A- 3 259 563

## Beschreibung

Die Erfindung betrifft eine Haltevorrichtung für zu galvanisierende Gegenstände, insbes. für Leiterplatten, mit Stabelementen, die mit Kontaktorganen zur Kontaktierung der von der Vorderseite der Haltevorrichtung zugeführten, zu galvanisierenden Gegenstände versehen sind.

Bei derartigen Haltevorrichtungen sind die Stabelemente vorzugsweise als sog. Drehstäbe ausgebildet, die mit den Kontaktorganen zur Kontaktierung der zu galvanisierenden Gegenstände versehen sind. Bei den Kontaktorganen handelt es sich bspw. um hakenförmige Elemente, die an den Drehstäben vorgesehen sind. Bei den bekannten Haltevorrichtungen der eingangs genannten Art ist es zwischen benachbarten Stabelementen jeweils möglich, einen einzigen zu galvanisierenden Gegenstand, d.h. insbes. eine einzige zu galvanisierende Leiterplatte mit den Kontaktorganen festzuklemmen und elektrisch leitend zu kontaktieren. Das bedeutet jedoch, dass mit den bekannten Haltevorrichtungen die Durchsatzleistung an galvanisierten Gegenständen, insbes. Leiterplatten, relativ gering ist.

Deshalb liegt der Erfindung die Aufgabe zugrunde, eine Haltevorrichtung der eingangs genannten Art zu schaffen, mit der es möglich ist, zwischen benachbarten Stabelementen mehr als einen zu galvanisierenden Gegenstand, insbes. Leiterplatte, anzuordnen und elektrisch leitend zu kontaktieren, so dass die Durchsatzleistung an galvanisierten Gegenständen wesentlich erhöht ist.

Diese Aufgabe wird erfindungsgemäss durch eine Haltevorrichtung gemäß Anspruch 1 gelöst. Dadurch, dass die Stützeinrichtungen an der Rückseite der Haltevorrichtung angeordnet sind, ist die Haltevorrichtung von ihrer Vorderseite her problemlos mit zu galvanisierenden Gegenständen, insbes. Leiterplatten, zu bestücken, ohne dass die Bestückung der Haltevorrichtung durch die Stützeinrichtungen behindert wird. Die Bestückung der Haltevorrichtung kann manuell oder vorzugsweise automatisch mit Hilfe eines bekannten, programmierbaren Roboters erfolgen. Dadurch, dass die länglichen Traversenelemente an den zugeordneten Säulen in der Höhe der Haltevorrichtung verstellbar sind, ist es möglich, an der Haltevorrichtung Gegenstände mit beliebigen Breitenabmessungen sicher zu befestigen, die Längenabmessung der zu galvanisierenden Gegenstände entspricht hierbei dem Abstand zwischen benachbarten Stabelementen und ist vorzugsweise konstant. Mit Hilfe der Stützeinrichtungen ist es demnach möglich, in der Haltevorrichtung nicht nur gleich grosse zu galvanisierende Gegenstände sicher festzuhalten und zu kontaktieren, sondern es ist auch möglich, in ein und derselben Haltevorrichtung auch Gegenstände unterschiedlicher Breitenabmessungen und konstanter Längsabmessungen sicher festzuhalten und zu kontaktieren, so dass zwischen einem Paar benachbarter Stabelemente bspw. drei zu galvanisierende Gegenstände und zwischen einem Paar anderer benachbarter Stabelemente vier oder mehr zu galvanisierende Gegenstände, insbes. Leiterplatten, anordenbar sind. Das bedeutet jedoch, dass sich mit der erfindungsgemässen Haltevorrichtung ein weites Einsatzgebiet ergibt, was die verschiedenen Abmessungsvarianten zu galvanisierender Gegenstände in ihrer Breitenabmessung gesehen bedeutet.

Die zu galvanisierenden Gegenstände, insbes. Leiterplatten, werden hierbei mittels der Stützorgane der Stützeinrichtungen voneinander auf Abstand gehalten, so dass auch die Randabschnitte der zu galvanisierenden Gegenstände problemlos galvanisierbar sind. Zu diesem Zweck sind die Stützorgane vorzugsweise lanzenförmig ausgebildet, um jeweils eine relativ kleine Auflagefläche für die zu galvanisierenden Gegenstände zu bilden. Die Stützorgane sind bei der erfindungsgemässen Haltevorrichtung in mindestens zwei unterschiedlichen Raumrichtungen verstellbar und somit einfach an die Abmessungen der zwischen benachbarten Stabelementen der Haltevorrichtung anzuordnenden Gegenstände anpassbar.

Um den Verstellbereich der einzelnen Stützorgane der Stützeinrichtungen noch weiter zu vergrössern, hat es sich als zweckmässig erwiesen, wenn die Stützeinrichtungen an den zugehörigen länglichen Traversenelementen verstell- und arretierbar angeordnet sind. Durch eine solche Ausbildung der Haltevorrichtung ist es möglich, jede einzelne Stützeinrichtung nicht nur in Bezug auf das zugehörige längliche Traversenelement wunschgemäss zu verstellen und zu arretieren, sondern gleichzeitig auch das Stützorgan im Bezug auf die Stützeinrichtung und/oder das zugehörige Traversenelement im Bezug auf die zugehörige Säule, entlang welcher das entsprechende Traversenelement verstellbar und arretierbar ist. Als vorteilhaft hat es sich erwiesen, wenn die Stützeinrichtungen entlang den zugehörigen Traversenelementen längsverstellbar ausgebildet sind. Möglich wäre es auch, die einzelnen Stützeinrichtungen im Bezug auf die zugehörigen Traversenelemente um die Längsachse der entsprechenden Traversenelemente herum verschwenkbar auszubilden.

Die Stützorgane der Stützeinrichtungen sind vorzugsweise im Bezug auf die Traversenelemente in einer zum entsprechenden länglichen Traversenelement senkrechten Ebene verstellbar. Das bedeutet, dass jedes einzelne Stützorgan die durch benachbarte Stabelemente aufgespannte Ebene und somit die Ebene der zwischen benachbarten Stabelementen angeordneten zu galvanisierenden Gegenstände, insbesondere Leiterplateten, mindestens annähernd senkrecht durchdringen kann, um mit Hilfe mindestens zweier Stützorgane jeweils einen zu galvanisierenden Gegenstand abzustützen, bis die zu galvanisierenden Gegenstände mit Hilfe der Stabelemente festgehalten und elektrisch leitend kontaktiert sind. Sobald die zu galvanisierenden Gegenstände mittels der Stabelemente festgehalten werden, können die Stützorgane in eine Ruhestellung zurückgestellt werden, in welcher die Stützorgane von den zu galvanisierenden Gegenständen entfernt sind.

Eine besonders platzsparende Ausbildung der Haltevorrichtung ohne Beeinträchtigung ihrer Betriebssicherheit ergibt sich, wenn jede Stützeinrichtung mit dem zugehörigen Stützorgan in einem Winkel zur Ebene zugehöriger benachbarter Stabelemente der Haltevorrichtung angeordnet ist, der von 90 Winkelgrad verschieden ist. In diesem Fall sind die einzelnen Stützeinrichtungen in Bezug auf die Stabelemente der Haltevorrichtung unter einem bestimmten Winkel geneigt ausgerichtet, so dass eine platzsparende Anordnung der Stützeinrichtungen möglich ist. Damit auch bei einer derartigen platzsparenden Anordnung der Stützeinrichtungen in Bezug auf die Stabelemente der Haltevorrichtung eine sichere Abstützung der zwischen benachbarten Stabelementen zu fixierenden, zu galvanisierenden Gegenstände gewährleistet bleibt, ist jedes Stützorgan vorzugsweise mit einer Abstützfläche ausgebildet, die zur Ebene zugehöriger benachbarter Stabelemente der Haltevorrichtung mindestens annähernd senkrecht ausgerichtet ist. Besonders vorteilhaft ist es, wenn hierbei die Abstützflächen der Stützorgane in Bezug auf die durch benachbarte Stabelemente aufgespannte Ebene derartig geneigt sind, dass sich durch Schwerkraftwirkung auf die einzelnen zu galvanisierenden Gegenstände eine sichere Anlage derselben an den Kontaktorganen der Stabelemente ergibt.

Eine einfache Ausbildung der erfindungsgemässen Haltevorrichtung ergibt sich, wenn jedem Paar von Stabelementen an jedem Traversenelement zwei Stützeinrichtungen zugeordnet sind. Bei den Stützeinrichtungen kann es sich um Hydraulikantriebe handeln, wobei die Stützorgane an den Kolbenstangen der Hydraulikantriebe ausgebildet sein können. Selbstverständlich wäre es auch möglich, die Stützeinrichtungen als elektromotorische Antriebe auszubilden.

Weitere Einzelheiten, Merkmale und Vorteile ergeben sich aus der nachfolgenden Beschreibung eines in der Zeichnung schematisch dargestellten Ausführungsbeispieles der erfindungsgemässen Haltevorrichtung für zu galvanisierende Gegenstände. Es zeigt:
- Fig. 1: eine Ansicht der Haltevorrichtung von vorne, und
- Fig. 2: eine Ansicht der Haltevorrichtung von der Seite.

Die Figuren zeigen eine Haltevorrichtung 10 für zu galvanisierende Gegenstände 12, bei denen es sich insbesondere um Leiterplatten handelt. Die Haltevorrichtung 10 weist voneinander beabstandet und zueinander parallel ausgerichtet Stabelemente 14 auf, die an Schienenelementen 16 angeordnet sind. Die Stabelemente 14 sind mit Kontaktorganen 18 ausgebildet, die zum Festhalten der zu galvanisierenden Gegenstände 12 und zur elektrisch leitenden Kontaktierung derselben dienen.

Um zwischen benachbarten Stabelementen 14, bei denen es sich um an sich bekannte Drehstäbe handeln kann, mehrere zu galvanisierende Gegenstände 12, d.h. insbes. Leiterplatten, anordnen zu können, dienen Stützeinrichtungen 20, mit denen die Gegenstände 12 mit ihrer Unterkante 22 genau definiert abgestützt werden, bis die zu galvanisierenden Gegenstände 12 mit Hilfe der Kontaktorgane 18 der Stabelemente 14 festgehalten und elektrisch leitend kontaktiert sind.

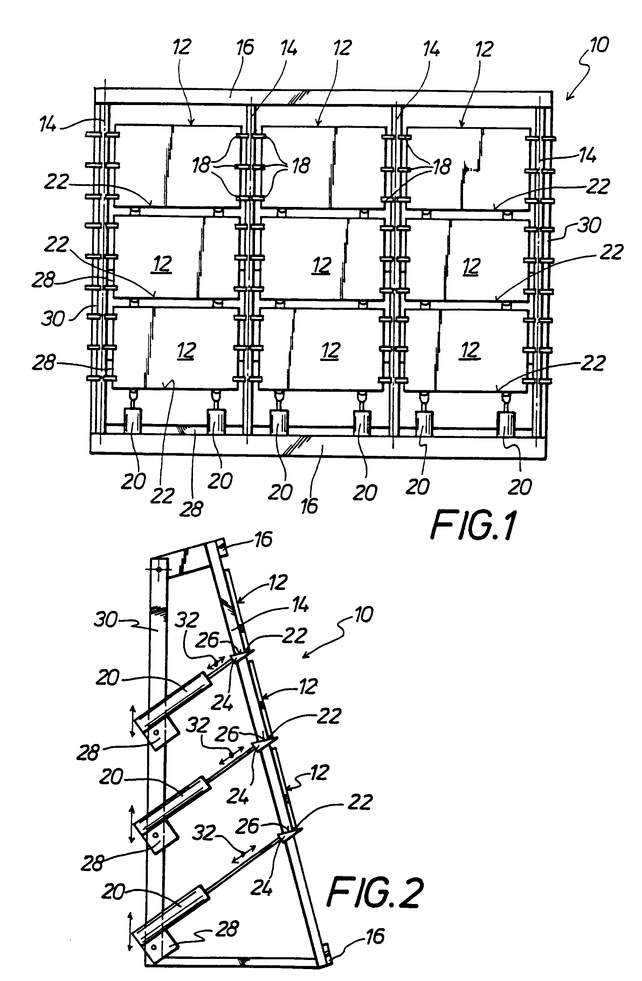

Wie aus Fig. 2 deutlich ersichtlich ist, weist jede Stützeinrichtung 20 ein Stützorgan 24 auf. Das/jedes Stützorgan 24 ist mit einer Abstützfläche 26 ausgebildet, an der der zugehörige zu galvanisierende Gegenstand 12 mit seiner Unterkante 22 in der aktiven Betriebsstellung der entsprechenden Stützeinrichtung 20 anliegt. Die Stützeinrichtungen 20 sind an länglichen Traversen 28 angeordnet, die an Säulen 30 verstell- und arretierbar sind. Die Stützeinrichtungen 20 können in Längsrichtung der zugehörigen Traversen 28 verstellbar ausgebildet sein. Die Stützorgane 24 der einzelnen Stützeinrichtungen 20 sind in Bezug auf die entsprechenden Stützeinrichtungen 20 beweglich ausgebildet, was durch die Doppelpfeile 32 in Fig. 2 angedeutet ist. Dadurch sind die Stützorgane 22 zwischen einer Ruhe- und einer aktiven Betriebsstellung verstellbar, wobei die Stützorgane 24 in der aktiven Betriebsstellung die von benachbarten Stabelementen 14 aufgespannte Ebene durchdringen, so dass an den Abstützflächen 26 von vorzugsweise einem Paar Stützeinrichtungen 20 jeweils ein zu galvanisierender Gegenstand 12 mit seiner Unterkante 22 genau definiert aufliegen kann. Sobald die gesamte Haltevorrichtung 10 mit zu galvanisierenden Gegenständen 12 bestückt und die zu galvanisierenden Gegenstände 12 mit Hilfe der Kontaktorgane 18 der Stabelemente 14 sicher festgehalten und elektrisch leitend kontaktiert sind, werden die Stützeinrichtungen 20 von der in Fig. 2 gezeichneten aktiven Betriebsstellung in eine inaktive Ruhestellung zurückgezogen, in welcher die Stützorgane 24 nicht länger die von benachbarten Stabelementen 14 aufgespannten Ebenen durchdringen, so dass die Haltevorrichtung 10 anschliessend mit den zwischen den Stabelementen 14 festgehaltenen und elektrich leitend kontaktierten Gegenständen 12 in eine Galvanisieranlage eingebracht werden kann.

## Patentansprüche

1. Haltevorrichtung für zu galvanisierende Gegenstände (12), insbes. für Leiterplatten, mit voneinander beabstandeten und Zueinander parallel ausgerichteten Stabelementen (14), die an Schienenelementen (16) angeordnet und mit Kontaktorganen (18) zur Kontaktierung der von der Vorderseite der Haltevorrichtung (10) zugeführten, zu galvanisierenden Gegenstände (12) versehen sind,
**dadurch gekennzeichnet**,
dass an der Rückseite der Haltevorrichtung (10), und mit dieser im Abstand verbunden Säulen (30) vorgesehen sind, entlang welchen längliche Traversenelemente (28) verstell- und arretierbar angeordnet sind, und dass an den Traversenelementen (28) Stützeinrichtungen (20) mit Stützorganen (24) für die zu galvanisierenden Gegenstände (12) angeordnet sind, wobei die Stützorgane (24) zur Abstützung der Gegenstände (12) in der von benachbarten Stabelementen (14) der Haltevorrichtung (10) aufgespannten Ebene anordenbar sind.

2. Haltevorrichtung nach Anspruch 1,
**dadurch gekennzeichnet**,
dass die Stützeinrichtungen (20) an den zugehörigen länglichen Traversenelementen (28) verstell- und arretierbar angeordnet sind.

3. Haltevorrichtung nach Anspruch 1 oder 2,
**dadurch gekennzeichnet**,
dass die Stützorgane (24) der Stützeinrichtung (20) in Bezug auf die Traversenelemente (28) in einer zum entsprechenden länglichen Traversenelement (28) senkrechten Ebene verstellbar sind.

4. Haltevorrichtung nach einem der vorhergehenden Ansprüche,
**dadurch gekennzeichnet**,
dass jede Stützeinrichtung (20) mit dem zugehörigen Stützorgan (24) in einem Winkel zur Ebene zugehöriger benachbarter Stabelemente (14) der Haltevorrichtung (10) angeordnet ist, der von 90 Winkelgrad verschieden ist.

5. Haltevorrichtung nach einem der vorhergehenden Ansprüche,
**dadurch gekennzeichnet**,
dass jedes Stüztorgan (24) mit einer Abstützfläche (26) ausgebildet ist, die zur Ebene zugehöriger benachbarter Stabelemente (14) der Haltevorrichtung (10) mindestens annähernd senkrecht ausgerichtet ist.

6. Haltevorrichtung nach einem der vorhergehenden Ansprüche,
**dadurch gekennzeichnet**,
dass jedem Paar von Stabelementen (14) an jedem Traversenelement (28) zwei Stützeinrichtungen (20) zugeordnet sind.

## Claims

1. A holding device for articles to be electroplated (12), in particular for circuit boards, with rod elements (14) interspaced from each other and aligned parallel to each other, which are arranged on rail elements (16), and which are provided with contact elements (18) for making contact with the articles (12) to be electroplated that are fed by the front side of the holding device (10),
**characterized in that**
provision is made for columns (30) at the rear side of the holding device (10) and connected thereto at a distance, along which columns there are arranged elongate cross members (28) with the facility of adjustment and of being locked in position, and that on the cross members (28) there are arranged supporting devices (20) with supporting elements (24) for the articles (12) to be electroplated, in which arrangement the supporting elements (24) for supporting the articles (12) can be arranged in the plane defined by adjoining rod elements (14) of the holding device (10).

2. A holding device according to claim 1,
**characterized in that**
the supporting devices (20) are arranged on the associated elongate cross members (28) with the facility of adjustment and of being locked in position.

3. A holding device according to claim 1 or 2,
**characterized in that**
the supporting elements (24) of the supporting device (20) are adjustable with respect to the cross members (28) in a plane that is perpendicular to the corresponding elongate cross member (28).

4. A holding device according to one of the preceding claims,
**characterized in that**
each supporting device (20) with the associated supporting element (24) is arranged at an angle other than 90 angular degrees to the plane of the associated adjoining rod elements (14) of the holding device (10).

5. A holding device according to one of the preceding claims,
**characterized in that**
each supporting element (24) is formed with a bearing surface (26) which is orientated at least approximately perpendicularly to the plane of the associated adjoining rod elements (14).

6. A holding device according to one of the preceding claims,
**characterized in that**
two supporting devices (20) are assigned to each pair of rod elements (14) on each cross member (28).

## Revendications

1. Dispositif de maintien pour des objets à galvaniser (12), en particulier pour des plaques conductrices, avec des éléments en forme de barreaux (14) agencés parallèles et à une certaine distance les uns des autres, et disposés sur des éléments en forme de rails (16) équipé d'organes de contact (18) pour la mise en contact des objets à galvaniser (12) amenés par la face avant du dispositif de maintien (10), caractérisé en ce que sur la face arrière du dispositif de maintien (10) et réunis à ce dernier avec un certain écart, sont prévus des colonnes (30) le long desquelles sont disposés des éléments transversaux (28) de façon réglable et immobilisable, et en ce que, à ces éléments transversaux (28) sont fixés des systèmes de butée (20) comportant des organes en butée (24) pour les objets à galvaniser, de manière telle que les organes de butée (24) pour l'appui des objets (12) puissent être ordonnés dans le plan voisin de celui des éléments en forme de barreaux (14) du dispositif de maintien (10)

2. Dispositif de maintien selon la revendication 1, caractérisé en ce que les systèmes de butée (20) sont adaptés de façon réglable et immobilisables aux éléments transversaux (28) correspondants en direction longitudinale.

3. Dispositif de maintien selon les revendications 1 ou 2, caractérisé en ce que l'organe de butée (24) d'un système de butée (20) est réglable par rapport aux éléments transversaux (28) dans un plan perpendiculaire à l'élément transversal (28) lui correspondant en direction longitudinale.

4. Dispositif de maintien selon l'une des revendications précédentes, caractérisée en ce que chaque système de butée (20) est disposé par rapport à l'organe de butée (24) correspondant suivant une direction angulaire par rapport au plan de l'élément en forme de barre (14) voisin du dispositif de maintien d'un angle différent de 90°.

5. Dispositif de maintien selon l'une des revendications précédentes, caractérisée en ce que chaque organe de butée (24) comporte une surface de butée (26) au moins à peu près perpendiculaire au plan de l'élément en forme de barre (14) voisin du dispositif de maintien (10).

6. Dispositif de maintien selon l'une des revendications précédentes, caractérisée en ce que, à chaque paire d'éléments en forme de barre (14) de chaque élément transversal (28) sont associés deux systèmes de butée (20).
